Europäisches Patentamt

**European Patent Office**

Office européen des brevets

(19)

(11) Publication number: **0 167 323**

**A2**

(12) # EUROPEAN PATENT APPLICATION

(21) Application number: **85304351.1**

(22) Date of filing: **18.06.85**

(51) Int. Cl.⁴: **H 01 L 31/06**
**H 01 L 31/18**

(30) Priority: **25.06.84 US 623860**

(43) Date of publication of application:
**08.01.86 Bulletin 86/2**

(84) Designated Contracting States:
**CH DE FR GB IT LI NL**

(71) Applicant: **ENERGY CONVERSION DEVICES, INC.**
**1675 West Maple Road**
**Troy Michigan 48084(US)**

(72) Inventor: **Hack, Michael**
**1860 Axtell, Apt. 3**
**Troy Michigan 48084(US)**

(72) Inventor: **Guha, Subhendu**
**Maple Apartments 17 629 West Maple Road**
**Clawson Michigan 48017(US)**

(74) Representative: **Jackson, Peter Arthur et al,**
**GILL JENNINGS & EVERY 53-64 Chancery Lane**
**London WC2A 1HN(GB)**

(54) **Stable photovoltaic devices and method of producing same.**

(57) An amorphous semiconductor photovoltaic device having improved long term efficiency stability. The improved stability is achieved by grading the band gap energy of a portion of the photo-responsive layer of the device. The widest band gap energy portion of the photo-responsive layer is disposed nearest the light-incident surface of the device. The band gap gradation may be smooth or stepped, and may be accomplished by varying the composition of the source materials during deposition of the photo-responsive layer.

FIG 1

EP 0 167 323 A2

ENERGY CONVERSION DEVICES, INC.        Ref: 50/2691/02

STABLE PHOTOVOLTAIC DEVICES        **0167323**
AND METHOD OF PRODUCING SAME

Thin film amorphous semiconductor materials offer several distinct advantage over crystalline materials. Amorphous semiconductors can be easily and economically fabricated into large-area photoresponsive devices by newly developed mass production processes. However, photoresponsive amorphous silicon-based semiconductor materials have historically degraded in performance over time as a result of prolonged exposure to light. This process, termed "photo-induced degradation", or "Staebler-Wronski degradation," is not fully understood. Photo-induced degradation is believed to result from the formation of defect states in the band gap of the material by broken semiconductor-semiconductor bonds. The photo-induced defects may be removed by annealing at a temperature of approximately 150°C for several hours.

The higher the quality of amorphous photovoltaic semiconductor material, the greater the degree of degrading by light. This observation is expected since lower quality amorphous photovoltaic semiconductor material includes a relatively high number of defect states and the formation of additional defect states under illumination is not as significant a change as in higher quality material which contains a lower initial defect density.

Photovoltaic cells that comprise a layer of intrinsic amorphous semiconductor material having a layer of p-type semiconductor material disposed on one side and a layer of n-type semiconductor material disposed on the opposite side are referred to as p-i-n cells. We have observed in such cells that photo-induced degradation causes a very large decrease in blue response as compared to the decrease in the red response. That is, the efficiency measured under blue illumination decreases much more than the efficiency measured under red illumination. "Blue illumination" is defined as having wavelengths from approximately 350 to 550 nanometers; "red illumination" is defined as having wavelengths from approximately 550 to 750 nanometers. It is known that blue light is absorbed in amorphous silicon alloy materials much more readily than red light. In fact, blue light is almost totally absorbed in the first hundred nanometers of the photo-active or intrinsic region of a p-i-n cell, but red light is absorbed throughout a greater volume of the intrinsic region. Blue illumination therefore produces a high density of charge carriers within a shal̃ow volume of the intrinsic region. The high density of carriers encourages recombination and decreases photocell efficiency, much like a high concentration of defect states in a degraded photovoltaic cell decreases efficiency.

In the invention, the problem of photo-induced degradation of amorphous semiconductor photovoltaic cells is attacked by changing the depth in the intrinsic region at which charge carriers are produced by blue illumination. The invention provides that blue light is absorbed throughout the intrinsic region, much as red light is, to discourage recombination either from a high density of light-generated charge carriers or from defects produced by prolonged illumination.

Light passing through a homogenous solid decreases in intensity at an exponential rate. In the invention, the solid, the photovoltaic cell, is constructed so that light intensity decreases at less than an exponential rate in the intrinsic region of the cell. The desired result is achieved by grading the band gap of the intrinsic layer of the photovoltaic cell. That is, the band gap energy of the layer varies spatially in the direction of light penetration. A relatively wide band gap energy region (for instance 1.9eV) is provided proximate the light incident surface of the intrinsic region and a narrower band gap energy region (for instance 1.7eV) is provided deeper in the region. The band gap energy grading includes smooth variations, abrupt, stepped variations and any combination of smooth and abrupt variations. The grading of the band gap energy of the intrinsic layer of a p-i-n type photovoltaic devices results in absorption of blue light throughout a substantial portion of the bulk of the intrinsic region and an increase of the effective lifetime of photo-generated charge carriers. The improved photovoltaic cells exhibit increased tolerance to defect states, that is to photo-induced degradation. It is not necessary to grade the entire layer of intrinsic material.

Figure 1 is a fragmentary, cross-sectional view of a multiple cell p-i-n photovoltaic device.

Figure 2 is a graph of the lifetime of holes generated by the absorption of blue and red illumination in the intrinsic semiconductor layer of a p-i-n photovoltaic device plotted as a function of position within the device.

Figure 3 is a graph of the recombination rate for holes (or electrons) generated by the absorption of blue and red illumination in the intrinsic semiconductor layer of both a degraded and a undegraded p-i-n photovoltaic device as a function of position within the device.

Figure 4 is a graph of the band gap energy of the intrinsic semiconductor material of a p-i-n type photovoltaic device as a function of the thickness of that layer, according to various embodiments of the invention.

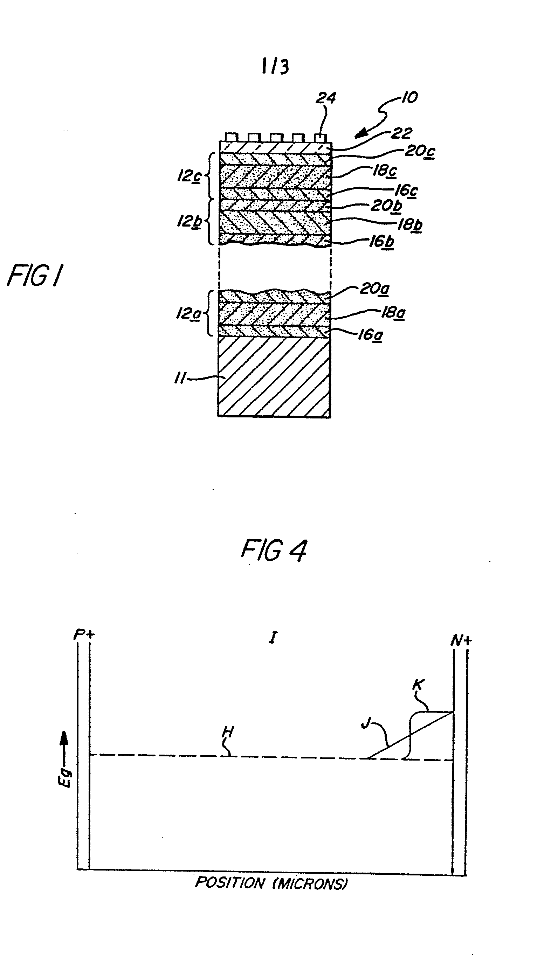

Figure 1 shows a p-i-n type photovoltaic device 10, such as a solar cell, made up of individual p-i-n type cells 12a, 12b, and 12c. A substrate 11 adjacent cell 12a forms one electrode of cell 10. Substrate 11 may be a metallic material such as stainless steel or aluminum, a thin electroformed member, such as nickel, or an insulating material, such as a glass or synthetic polymer, bearing an electrically conductive electrode layer. Certain applications may require a thin oxide layer and/or a series of base contacts and/or a reflecting layer be disposed on substrate 11 prior to the deposition of the semiconductor material. As used here, the term "substrate" includes any elements added by preliminary processing.

Each of cells, 12a, 12b, and 12c is fabricated with an amorphous semiconductor body containing at least a silicon or germanium alloy. Each of the semiconductor bodies includes an n-type conductivity semiconductor layer 20a, 20b, and 20c; a graded band gap intrinsic semiconductor layer 18a, 18b and 18c; and a p-type conductivity semiconductor layer 16a, 16b and 16c. As illustrated, cell 12b is an intermediate cell and, as indicated in Figure 1, additional intermediate cells may be stacked on the illustrated cells without departing from the spirit or scope of the present invention.

A transparent conductive oxide (TCO) layer 22, formed in the preferred embodiment of indium tin oxide, is deposited on cell 12c and forms a second electrode. A metallic electrode grid 24 is preferably applied to layer 22 for efficient current collection.

Recombination of charge carriers is a major factor in determining the losses in the conversion efficiency of photovoltaic devices. In p-i-n type photovoltaic cells, it has been found that the recombination of charge carriers near the light-incident surface of the intrinsic semiconductor is controlled by hole lifetime, since holes represent minority charge carriers in this region. Based upon laboratory observation and computer simulations of p-i-n photovoltaic devices, it has been determined that effective hole lifetime depends upon the wavelength of the incident radiation producing the holes. Red light produces holes having longer effective lifetimes than holes generated by blue light. Since the semiconductor material in amorphous silicon photovoltaic cells are typically extremely thin, bulk properties, such as characteristic carrier lifetimes are not manifested. Therefore, it is correct to speak of "effective carrier lifetimes" when discussing charge carriers in such photovoltaic cells.

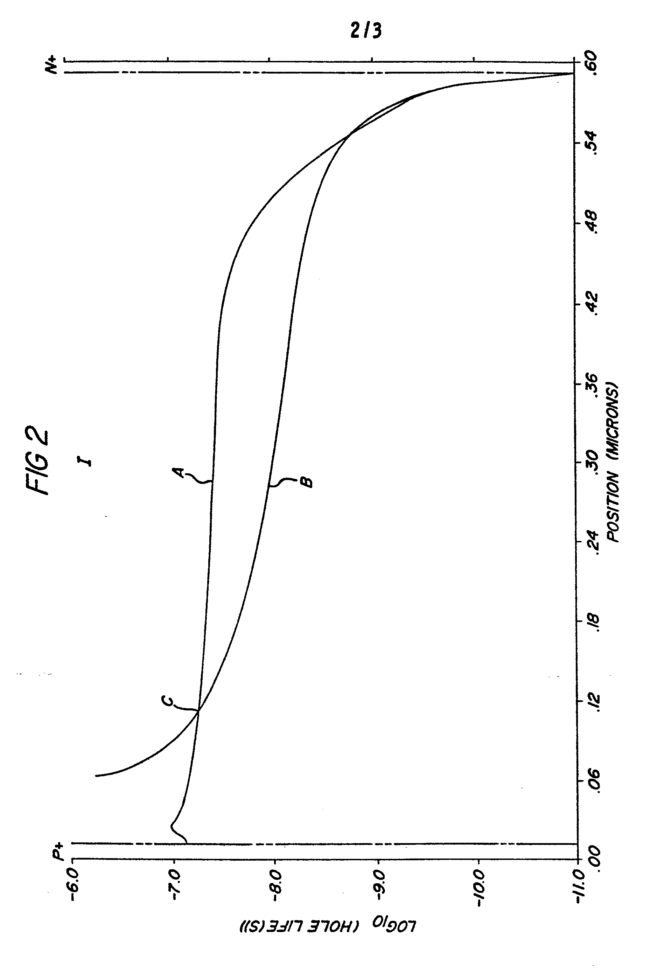

Figure 2 is a graphical representation of hole (or electron) lifetime in the intrinsic semiconductor layer of a p-i-n photovoltaic device at various positions in that intrinsic layer. Curve A represents holes generated by red illumination and curve B represents holes generated by blue illumination. Figure 2 was derived from a computer simulation of a p-i-n photovoltaic device illuminated through the n-type layer with a flux of $10^{16}$ photons per $cm^2$. Plotted along the abscissa is the position, in microns, within the intrinsic semiconductor layer of the photovoltaic cell. The ordinate shows the logarithm of hole lifetime as measured in seconds. The intrinsic layer of amorphous silicon alloy material was determined to possess an absorption coefficient of $2X10^3 cm^{-1}$ with respect to red light. Curve B similarly depicts the lifetime of holes generated by the absorption of blue radiation in the intrinsic layer of amorphous silicon alloy material. The absorption coefficient for blue light was determined to be of $2X10^5 cm^{-1}$.

The coefficient of absorption of blue light in the amorphous silicon alloy material is two orders of magnitude greater than that of the red light. For this reason, most of the absorption of blue light will occur proximate (i.e. within 100 nanometers of) the light-incident surface of the intrinsic region. The absorption of red light will occur more uniformly throughout the bulk of the intrinsic layer. As a result of this differential light absorption in the intrinsic material, there is a differential distribution of holes generated by the absorption of the photons of light.

If the absorption characteristics of the intrinsic layer for blue light could more closely approximate the absorption characteristics of red light, the effective lifetimes of holes generated by red and blue light would be about the same. If those effective lifetimes are about the same, a lower loss in efficiency upon photo-induced degradation will occur.

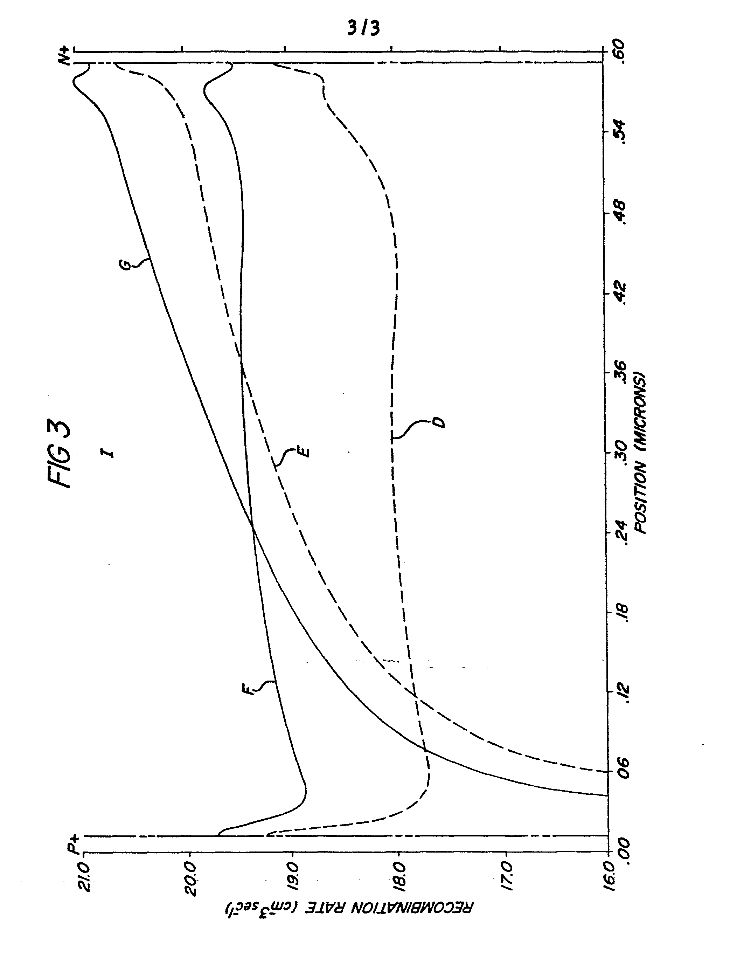

Figure 3 is a graph of the recombination rate for holes (or electrons) at various positions in a p-i-n type photovoltaic device, for both a degraded and an undegraded semiconductor material, under both red and blue light. Light-induced degradation was computer simulated by increasing both the minimum density of states and the charge carrier capture cross section of the recombination centers by an order of magnitude. Curves D and E, respectively, represent the hole recombination rate of an undegraded photovoltaic device under red and blue illumination. Curves F and G, respectively, represent the hole recombination rate of a degraded device under red and blue illumination. The lowest hole recombination rate, exhibited by the undegraded device under red illumination, is relatively uniform throughout the thickness of the intrinsic layer, neglecting variations due to interface defects which occur in the immediate proximity of the interfaces between the intrinsic and doped layers. Even after light-induced degradation, the rate of hole recombination under red illumination remains relatively uniform and relatively low. The undegraded device under red illumination of approximately $10^{16}$ photons per square centimeter per second produced a short circuit current of approximately 0.9 mA, while the degraded photovoltaic device produced a short circuit current of 0.68 mA.

While the rate of hole recombination is relatively high in the undegraded device (curve E) the rate of hole recombination is much higher after degradation (curve G). Therefore, the rate of recombination for blue generated charge carriers varies greatly throughout the intrinsic layer, with the highest rate of hole recombination occuring in the first third of the intrinsic layer. This high hole recombination rate is reflected in the photo-induced loss of efficiency. The undegraded device represented by curve E generates a short circuit current of 1.14 mA upon illumination with a flux of $10^{16}$ photons per square centimeter per second, but the photo-induced degraded device generates a short circuit current of only 0.11 mA under the same conditions. This difference represents a 90 percent loss in efficiency.

In curves D through G, the loss in efficiency of the device upon photo-induced degradation is primarily due to the loss of blue response. That loss is most severe in approximately the first one hundred nanometers of the light-incident side of the layer of intrinsic material and correlates to the higher absorption of blue light as compared to absorption of red light.

In our invention, uniform absorption of both blue and red light is promoted by grading the band gap energy of the semiconductor material that forms the intrinsic layer. Incident light is absorbed more deeply in the bulk thickness of the intrinsic region of the device avoiding the formation of a high density of charge carriers proximate the light-incident surface. In other words, stability of the photovoltaic device is increased by distributing charge carriers more uniformly throughout the bulk thickness of the intrinsic region.

Figure 4 is a graphic representation of a p-i-n type photovoltaic device illustrating several variations in the band gap energy of the intrinsic region according to the invention. In prior art photovoltaic devices, the band gap energy is constant throughout the intrinsic region, as indicated by dashed line H. In the invention, the band gap energy of the intrinsic layer is graded in a uniform or stepped fashion. Curve J shows a smoothly varying, graded band gap intrinsic semiconductor material. The band gap energy of the layer of intrinsic semiconductor material represented by curve J, varies linearly from a highest initial value at the n-type layer-intrinsic layer interface to a lowest value represented by the line H, at a point approximately 1/3 of the way into the bulk thickness of that intrinsic layer. In an alternative embodiment, rot illustrated, the band gap energy may vary smoothly, in the manner illustrated by curve J, but in a non-linear manner, e.g., the variation in band gap energy with increasing thickness of the intrinsic semiconductor material may be exponential.

In another embodiment of the invention, the band gap of the intrinsic layer is graded in an abrupt or step manner, as illustrated by curve K. Curve K shows two levels of band gap energy (i.e. one step), but the band gap energy may be varied through the use of as great a number of steps as deemed convenient. Curves J and K depict the band gap energy as graded through only a portion of the bulk thickness of the intrinsic semiconductor layer. The entire thickness of the intrinsic layer need not be band gap graded in order to spread the absorption of blue light. It has been found that if the initial one to two hundred nanometers of the intrinsic layer is band gap graded, the desired absorption will be promoted to secure improved stability.

Photovoltaic devices according to the invention may be manufactured by any of several known thin film deposition processes, including sputtering, evaporation, chemical vapor deposition, or glow discharge deposition.

Certain elements, including nitrogen, oxygen, fluorine and carbon, whether taken alone or in combination, are capable of widening the band gap of amorphous silicon and germanium alloy materials. Accordingly, the improved, more stable photovoltaic device of the instant invention may be fabricated by incorporating increasing amounts of one or more band gap widening elements into the amorphous semiconductor alloy material of the intrinsic layer of a p-i-n photovoltaic device as that intrinsic layer is being deposited. Alternatively, band gap narrowing elements, such as germanium, tin, lead, and mixtures thereof, may be employed to narrow the band gap of amorphous semiconductor materials such as silicon and germanium alloys. By utilizing this approach to band gap grading, decreasing amounts of band gap narrowing elements are added to the intrinsic layer of semiconductor material as it is deposited.

An embodiment of the instant invention, a p-i-n type photovoltaic device, was prepared by a glow discharge deposition technique. A p-doped semiconductor layer less than 20 nanometers thick was deposited upon a stainless steel substrate by the glow discharge decomposition of a gas mixture comprising silane, hydrogen and diborane gas, through the application of radio frequency energy of approximately 13.56 megahertz at a gas pressure of approximately 66.7 pascal. Upon completion of the deposition of the p-doped layer, the deposition chamber was purged and a process gas mixture for depositing a layer of intrinsic amorphous silicon alloy material was admitted. The precursor intrinsic process gas mixture comprised silane and hydrogen, and the pressure within the deposition chamber was maintained at approximately 66.7 pascal. The decomposition of the process gas mixture and the deposition of the intrinsic semiconductor alloy layer was initiated by the application of radio frequency energy and allowed to proceed until approximately 400 nanometers of intrinsic amorphous silicon alloy material was deposited. At that time, ammonia, equal to 30% of the amount of silane present, was admitted into the deposition chamber and the deposition process proceeded until approximately an additional 100 nanometers of intrinsic amorphous silicon:nitrogen alloy material was deposited. In this manner, a graded band gap structure comprising approximately 400 nanometers of an intrinsic amorphous silicon alloy material and 100 nanometers of amorphous silicon:nitrogen alloy material was deposited. Following the deposition of the graded intrinsic semiconductor layer, a layer of less than approximately 20 nanometers thickness of n-doped amorphous silicon alloy material was deposited on the intrinsic semiconductor layer by the glow discharge decomposition of a process gas mixture comprising silane, hydrogen and phosphine. In a subsequent processing step, a transparent electrode formed of indium tin oxide was deposited on the layer of n-doped semiconductor alloy material in a reactive evaporation process.

A pair of p-i-n type photovoltaic devices specifically including t nd gap graded intrinsic layers were fabricated by glow discharge deposition. The devices comprised an aggregate of layers formed on stainless steel substrates. Each aggregate of layers included an approximately 10 nanometer thick layer of p-type semiconductor material fabricated by the glow discharge decomposition of a mixture of silane and diborane; and an approximately 10 nanometer thick layer of n-type semiconductor mate⁻ial fabricated by the glow discharge decomposition of silane and phosphine. Disposed between the p-type and n-type layers is the graded band gap layer of intrinsic semiconductor material according to the invention. The graded band gap layer comprises a first approximately 400 nanometer thick portion formed of an amorphous silicon:hydrogen alloy having a band gap of approximately 1.7 electron volts, disposed immediately on the p-layer; and a second approximately 100 nanometer thick portion formed of an amorphous silicon:hydrogen:nitrogen alloy having a band gap of approximately 1.9 electron volts disposed on the 1.7 electron volt portion. Deposition of both of the band gap graded intrinsic layer portions was accomplished by a glow discharge process. The 1.7 electron volt portion of the intrinsic layer was deposited by the decomposition of silane, and the 1.9 electron volt portion was deposited by the decomposition of a mixture of 30 percent ammonia and 70 percent silane. For purposes of comparison and control, a similar p-i-n photovoltaic device having a 500 nanometer thick, ungraded intrinsic layer of semiconductor material with a constant 1.7 electron volt band gap was prepared in an identical glow discharge deposition process.

This particular device configuration with a relatively thick single p-i-n photovoltaic cell is known to show a high degree of photo-induced degradation. Initial operational parameters were measured, and the devices were then subjected to prolonged exposure to AM-1 (i.e. one sun directly overhead reduced by atmospheric losses) illumination. Short circuit current under blue illumination was measured after 6 and 72 hours of AM-1 illumination. After 6 hours of illumination, the blue light short circuit current of the test devices were 96.0 percent and 97.1 percent of the initial values, while for the control device it was 72 percent of its original value. After 72 hours, the test devices still exhibited 91.3 percent and 90.3 percent of their initial blue light short circuit currents, while the control device fell to 54 percent of its initial value.

While the foregoing description has dealt primarily with p-i-n type photovoltaic devices, the invention is equally applicable to n-i-p devices illuminated on the p-doped semiconductor layer side. In such devices the electrons represent the minority charge carriers and therefore determine cell efficiency. Accordingly, the previous discussion relative to holes will be applicable to electrons in n-i-p devices. The principles of the invention may be similarly applied to other photo-responsive devices, such as p-n devices, or Schottky barrier devices, in which a photo-responsive region is formed in a semiconductor material at an interface with a metallic layer.

CLAIMS

1. An improved amorphous semiconductor photovoltaic device (10) having a light-incident surface and at least one set (12a) of successive layers beneath said surface for receiving light and generating charge carriers in response to said light, said set including a p-type layer (20a), an adjacent intrinsic layer (18a) and an n-type layer (16a) adjacent to said intrinsic layer (18a) opposite said p-type region (20a) characterized in that said intrinsic layer (18a) includes a graded band gap energy through a portion of said region, the widest band gap energy being disposed in said intrinsic layer nearest said light-incident surface.

2. The device of claim 1 characterized in that the intrinsic layer (18a) includes a gradient of band gap energy reducing material.

3. The device of claim 2 characterized in that said band gap energy reducing material is chosen from the group consisting essentially of germanium, tin, lead and mixtures thereof.

4. The device of claim 1 characterized in that the intrinsic layer (18a) includes a gradient of band gap energy increasing material.

5. The device of claim 4 characterized in that the band gap energy increasing material is chosen from the group consisting essentially of nitrogen, oxygen, carbon, fluorine and mixtures thereof.

6. The device of claim 1 characterized in that the widest band gap portion of the intrinsic region (18a) has a band gap energy of approximately 1.8 to 2.1 electron volts and the narrowest gap portion has a band gap energy of approximately 1.5 to 1.8 electron volts.

7. The photovoltaic device of claim 1 characterized in that the band gap energy of the intrinsic layer (18a) is smoothly graded.

8. The device of claim 1 characterized in that the band gap energy of the intrinsic layer is graded in an abrupt step.

9. A method of producing an improved amorphous semiconductor photovoltaic device having a light-incident surface and at least one set of successively deposited layers disposed beneath said surface for receiving light and generating charge carriers in response to said light, said method including depositing a n-type layer, depositing an intrinsic layer on said n-type layer and depositing a p-type layer on said intrinsic layer opposite said n-type layer, characterized in that a portion of said intrinsic layer is co-deposited with a band gap energy altering material to grade the band gap energy of said intrinsic layer, the widest band gap energy being disposed in said intrinsic layer nearest said light-incident surface.

10. The method of claim 9 characterized in that said band gap energy altering material is a band gap energy reducing material.

11. The method of claim 10 characterized in that said band gap energy reducing material is chosen from the group consisting essentially of germanium, tin, lead and mixtures thereof.

12. The method of claim 9 characterized in that said band gap energy altering material is a band gap energy increasing material.

13. The method of claim 12 characterized in that the band gap energy increasing material is chosen from the group consisting essentially of nitrogen, oxygen, carbon, fluorine and mixtures thereof.

14. The method of claim 9 charterized in that the amount of said band gap energy altering material co-deposited with said intrinsic layer is gradually changed during the deposition of said intrinsic layer.

15. The method of claim 9 charterized in that the amount of said band gap energy altering material co-deposited with said intrinsic layer is abruptly changed during the deposition of said intrinsic layer.

1/3

FIG 1

FIG 4

FIG 2

POSITION (MICRONS)

LOG₁₀ (HOLE LIFE (S))

P+    N+

I

A

B

C

FIG 3